(19) Europäisches Patentamt
European Patent Office
Office européen des brevets

(11) Veröffentlichungsnummer: **0 293 656 B1**

# (12) EUROPÄISCHE PATENTSCHRIFT

(45) Veröffentlichungstag der Patentschrift: **25.11.92**

(51) Int. Cl.⁵: **G03F 7/004**

(21) Anmeldenummer: **88107687.1**

(22) Anmeldetag: **13.05.88**

Die Akte enthält technische Angaben, die nach dem Eingang der Anmeldung eingereicht wurden und die nicht in dieser Patentschrift enthalten sind.

## (54) Verfahren zur Bebilderung lichtempfindlichen Materials.

(30) Priorität: **20.05.87 DE 3716848**

(43) Veröffentlichungstag der Anmeldung:
**07.12.88 Patentblatt 88/49**

(45) Bekanntmachung des Hinweises auf die Patenterteilung:
**25.11.92 Patentblatt 92/48**

(84) Benannte Vertragsstaaten:
**DE FR GB**

(56) Entgegenhaltungen:
**EP-A- 0 022 571**
**EP-A- 0 130 599**
**DE-A- 3 325 022**

(73) Patentinhaber: **HOECHST AKTIENGESELLSCHAFT**
**Postfach 80 03 20**
**W-6230 Frankfurt am Main 80(DE)**

(72) Erfinder: **Stahlhofen, Paul, Dr. Dipl.-Chem.**
**Leibnizstrasse 18/b**
**W-6200 Wiesbaden(DE)**
Erfinder: **Mohr, Dieter, Dr. Dipl.-Chem.**
**Eaubonner Strasse 8**
**W-6501 Budenheim(DE)**

EP 0 293 656 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur Bebilderung lichtempfindlichen Materials aus einem Schichtträger und einer normalerweise positiv arbeitenden lichtempfindlichen Schicht, bei dem man die lichtempfindliche Schicht durch Belichtung mittels UV-Licht aktiviert, die Bebilderung mittels thermischer Energie vornimmt und die Entwicklung mit einem wäßrig-alkalischen Entwickler durchführt.

Mit wachsenden Fortschritten in der Digitaltechnik und steigendem Angebot an entsprechenden Speichermedien steigt auch das Bedürfnis nach digitalbebilderbaren Druckplatten. In der Technik der Druckformherstellung sind bereits verschiedene Vorschläge gemacht worden, die das Ziel verfolgen, Druckplatten ohne den Zwischenschritt über eine Silberfilmmaske zu bebildern.

In der DE-OS 2 318 133, entsprechend US-PS 3,836,709, wird ein Verfahren zur Herstellung eines polymeren Bildes mittels Laserstrahlen beschrieben, bei dem eine Schicht mit photohärtbarer Zusammensetzung benötigt wird.

Die DE-AS 2 231 815 beschreibt die Bebilderung von nichtlichtempfindlichen Schichten mit Elektronenstrahlen zur Herstellung negativer Reliefs. Das Verfahren ist technisch aufwendig und ist infolge der Beschichtungsart nur für relativ niedrige Druckauflagen geeignet. Infolge des technischen Aufwands und der geringen Auflage hat sich das Verfahren praktisch nicht durchgesetzt.

In der US-PS 3,664,737 wird eine Druckplatte mit einer lichtempfindlichen, negativ arbeitenden Schicht beschrieben, die mit einem Laser bestrahlt wird, während aus der DE-OS 24 48 325, entsprechend US-PS 4,034,183, ein Verfahren zur Herstellung von Flachdruckformen bekannt ist, bei dem ein mit einer hydrophilen, nicht lichtempfindlichen Schicht bedeckter Schichtträger bildmäßig mit Laserstrahlen bestrahlt und mit dem bestrahlten Material ohne weitere Behandlungsschritte in einer Flachdruckmaschine gedruckt wird.

In der DE-PS 27 28 947, entsprechend GB-PS 1,583,329, wird ein Verfahren zur Herstellung von Flachdruckformen beschrieben, bei dem eine Flachdruckplatte aus einem anodisch oxidierten Aluminiumträger und einer lichtempfindlichen Schicht, die aus einer negativ arbeitenden, lichthärtbaren Diazoverbindung und einem Aminharz besteht, bildmäßig mit einem Laserstrahl bestrahlt wird.

Die EP-OS 0 164 128 beschreibt lichtempfindliche Kopiermaterialien und ein Verfahren zur Bebilderung derselben mittels YAG-Laser.

Mit all den bekannt gewordenen Methoden sind jedoch verschiedene Nachteile verknüpft. Entweder sind unwirtschaftlich arbeitende Laser zur Bebilderung notwendig, zum Beispiel im UV arbeitende Argonionen-Laser oder die verwendeten Systeme, wie zum Beipsiel $CO_2$-Laser, erfordern einen hohen sicherheits-und gerätetechnischen Aufwand.

Die bisher bekannten Laser empfindlichen Schichten haben ferner den Nachteil, daß einerseits die relativ hochlichtempfindlichen Schichten, wie beispielsweise die in DE-OS 27 28 858, entsprechend GB-PS 1,583,330, für die Belichtung mit Argonionenlaser beschriebenen Schichten, nur eine sehr beschränkte thermische Stabilität und damit eine ungenügende Lagerfähigkeit aufweisen, während die Schichten gemäß DE-OS 24 48 325, entsprechend US-PS 4,034,183, zwar thermisch sehr stabil sind, andererseits aber zur Bebilderung extrem hohe Energien erfordern. Nachteilig ist ferner, daß die Reduzierung der erforderlichen Energien zur Aushärtung der Schicht immer auf Kosten der thermischen Stabilität geht.

Aus US-PS 4,544,627 ist ein negativ arbeitendes Bebilderungsverfahren bekannt, bei dem das lichtempfindliche Material, das eine o-Chinondiazidverbindung und eine basische Verbindung, die die Umwandlung der Chinondiazidverbindung in ein unlösliches Indencarbonsäurederivat erleichtert, in der lichtempfindlichen Schicht enthält, vollflächig bestrahlt, mit Laserlicht bildmäßig belichtet und anschließend entwickelt wird. Es hat sich jedoch gezeigt, daß derartige Schichten noch nicht höchsten Ansprüchen genügen, da sie zu lichtunempfindlich sind und das Arbeiten in Repetiermaschinen nicht voll gewährleisten.

Aufgabe der Erfindung war es, ein Verfahren zur Bebilderung lichtempfindlichen Materials, wie Druckplatten mit Laserstrahlen oder mit Elektronenstrahlen oder thermischen Bebilderungsmethoden, wie mit einem Thermodrucker vorzuschlagen, das diese Nachteile nicht hat und wobei das bei allen bisher beschriebenen Verfahren bestehende Mißverhältnis zwischen Lagerstabilität des Materials und der Einsatzmöglichkeit von wirtschaftlichen und digital arbeitenden Bebilderungsverfahren überwunden wird.

Die Aufgabe wird bei dem Verfahren der eingangs genannten Art unter Verwendung eines normalerweise positiv arbeitenden Kopiermaterials, dadurch gelöst, daß man in der lichtempfindlichen Schicht ein Gemisch aus einer Verbindung mit mindestens einer durch Säure spaltbaren -C-O-C-oder -C-O-Si- Bindung und einer bei Belichtung eine starke Säure bildenden Verbindung verwendet und die Bebilderung in dem aktivierten Bereich mittels Laser-oder Elektronenstrahlen oder mit Hilfe eines Thermodruckers durchführt. Vorzugsweise verwendet man zur thermischen Bebilderung einen Hochleistungs-Ionenlaser mit einer Emission über 500 nm. Im Falle der thermischen Bebilderung mit Elektronenstrahlen verwendet man

vorzugsweise solche mit einer Stromstärke von mindestens 1 µA und einer Beschleunigungsspannung von über 10 kV. Die thermische Bebilderung wird vorzugsweise durch eine punktweise Erwärmung mit einem Thermodrucksystem durchgeführt.

Die bei dem erfindungsgemäßen Verfahren eingesetzten Kopiermaterialien, besitzen die Eigenschaft, daß die belichteten Schichtbereiche thermisch härtbar sind. Diese Eigenschaft wird erfindungsgemäß ausgenutzt. Die hochlichtempfindliche, normalerweise positiv arbeitende Kopierschicht, welche sich durch eine sehr gute Lagerfähigkeit und thermische Stabilität auszeichnet, wird durch Licht aktiviert, d.h. nach vorangegangener Belichtung kann die Schicht unter dem Einfluß thermischer Energie bildmäßig ausgehärtet werden.

Umkehrverfahren zur Herstellung negativer Kopien mittels eines lichtempfindlichen Kopiermaterials auf Basis von 1,2-Chinondiaziden mit Hilfe von UV-Licht unter Verwendung der üblichen Kopiergeräte wie Röhrenlampen, Xenonimpulslampen, metallhalogeniddotierte Quecksilberdampflampen oder Kohlenbogenlampen sind bekannt. Derartige Umkehrverfahren erfordern jedoch geeignete Zusatzstoffe zur Kopierschicht und eine bestimmte Folge von Behandlungsschritten. In der GB-PS 2,082,339 wird ein derartiges Umkehrverfahren beschrieben, bei dem ein lichtempfindliches Gemisch, bestehend aus einem 1,2-Chinondiazid und mindestens einem Resol, nach einer Folge von bestimmten Verarbeitungsschritten auch als negativ arbeitendes Aufzeichnungsmaterial verarbeitet werden kann. In den DE-OS 28 55 723 und 25 29 054, entsprechend US-PS 4,104,070, werden Resistschichten auf Basis von 1,2-Chinondiaziden für ein Umkehrverfahren beschrieben, die als Zusatzstoff N-Acyl-N'-methylethylendiamin oder Hydroxyethylimidazolin enthalten. Ein ähnliches Material mit einem Gehalt an sekundären oder tertiären Aminen wird in der US-PS 4,196,003 beschrieben, während in EP-OS 0 133 216, entsprechend US-PS 4,581,321, ein Umkehrverfahren beschrieben wird, welches als Zusatz zur Chinondiazid haltigen Kopierschicht einen Hexamethylolmelaminether enthält.

Diese Umkehrverfahren haben prinzipiell die gleiche Folge von Verarbeitungsschritten, wobei nach der bildmäßigen Belichtung unter einem Negativfilm die Druckplatte 1 - 5 Minuten auf 100 -150 °C erwärmt wird, nach dem Abkühlen nochmals ohne Vorlage vollflächig nachbelichtet und dann mittels eines wäßrig-alkalischen Entwicklers entwickelt wird. Die Bildumkehr beruht darauf, daß die Lichtzersetzungsprodukte beim Erwärmen ein unlösliches Reaktionsprodukt ergeben.

Gegenstand der Erfindung ist auch ein Verfahren zur Herstellung einer Druckform mittels eines lichtempfindlichen Materials aus einem Schichtträger und einer lichtempfindlichen Schicht, bei dem das lichtempfindliche Material unter einer Positiv-Vorlage belichtet und in den Nichtbildbereichen des Positiv-Bildes mittels Laser- oder Elektronenstrahlen oder mit thermischen Bebilderungsmethoden wie einem Thermodrucker bebildert und anschließend mittels eines wäßrig-alkalischen Entwicklers entwickelt wird.

Geeignete Laser für die Zwecke der vorliegenden Erfindung sind alle leistungsgerechten Laser, die vorzugsweise bei Wellenlängen größer 500 µm emittieren, zum Beispiel Krypton- oder YAG-Laser. Daneben können zur Bebilderung auch die Bestrahlung mit Elktronenstrahlen oder Methoden, wie sie in Thermodruckern Einsatz finden, herangezogen werden.

Thermodrucker besitzen aufheizbare Metallnadeln, deren Temperatur gesteuert wird. Die Bebilderung der thermosensitiven Kopierschicht wird durch entsprechende Erhitzung des Thermokopfes am Thermodrucker erreicht.

Zur ganzflächigen Belichtung mit UV-Licht bzw. zur Aktivierung der lichtempfindlichen Schicht für die thermische Bebilderung können die üblichen Kopiergeräte wie Röhrenlampen, Xenonimpulslampen, metallhalogeniddotierte Quecksilberdampflampen oder Kohlenbogenlampen verwendet werden. Der Laserstrahl wird mittels einer vorgegegebenen programmierten Strich- und/oder Rasterbewegung gesteuert. Verfahren und Vorrichtungen zur Regelung des Laserstrahles durch Computer sowie die Bündelung, Modulation bzw. Ablenkung des Strahles sind nicht Gegenstand dieser Erfindung. Sie sind mehrfach beschrieben, beispielsweise in den US-PS 3 751,587, 3 745,586, 3 747 117, 3 475 760, 3 506 779 und 3 664 737.

Das erfindungsgemäße Verfahren ermöglicht ferner neben den bekannten positiven Bebilderungsverfahren zusätzlich die Bebilderung mit Laserstrahlen, Elektronenstrahlen oder Thermodruckern nach vorhergehender Bebilderung mit einer der obengenannten Methoden in den belichteten Nichtbildstellen eines Positivbildes.

Zur Herstellung einer Druckform wird beispielsweise die normalerweise positiv arbeitende Kopierschicht vollflächig ausbelichtet, anschließend mittels Laser- oder Elektronenstrahlen bebildert und dann ohne weitere Zwischenbehandlung mit Hilfe einer wäßrig-alkalischen Lösung entwickelt. Neben dieser relativ einfachen Bebilderung mit wärmeerzeugenden Laser- oder Elektronenstrahlen lassen sich auch vorteilhaft verschiedene Kombinationsmöglichkeiten beim Zusammenkopieren von Strich-und Rasterfilmen verwirklichen (Photocomposing). So kann man beispielsweise zunächst mit Hilfe von UV-Licht und eines Diapositivs ein positives Bild erzeugen und anschließend an den vom Licht getroffenen und noch nicht bebilderten

Schichtbereichen, mit Laserstrahlen nochmals, gegebenenfalls mehrmals, weitere Bilder auf die Druckplatte nachträglich einkopieren. Die so bebilderte Druckplatte wird dann ohne weitere Zwischenschritte entwickelt, wonach man die fertige Druckform erhält.

Der Vorteil des erfindungsgemäßen Verfahrens zur thermischen Bebilderung liegt darin, daß im Gegensatz zu den bisher bekannten Umkehrverfahren der zusätzliche Wärmeschritt in einem Temperofen (1-5 Minuten bei 100 - 150 ° C) nicht erforderlich ist. Für die Aktivierung der Kopierschicht zum Zwecke der Bebilderung genügt lediglich ein vorangehender Belichtungsschritt mittels UV-Licht. Ein weiterer Vorteil ist die ausgezeichnete Lagerfähigkeit der Druckplatten wie sie vorzugsweise im Sinne der Erfindung verwendet werden, da im Gegensatz zu den bekannten Schichten für Laserbebilderung die thermische Empfindlichkeit erst durch die vorangehende Belichtung erzeugt wird und darüberhinaus im Gegensatz zu den Schichten für das Umkehrverfahren die Kopierschichten keine weiteren basischen oder sauren Zusätze benötigen, welche bei den bekannten Umkehrverfahren die Aushärtung der belichteten Bildberiche erst möglich machen.

Ein weiterer Vorteil des in dem erfindungsgemäßen Verfahren verwendeten lichtempfindlichen Materials besteht in seiner relativ großen Lichtempfindlichkeit gegenüber den bekannten auf o-Chinondiaziden basierenden lichtempfindlichen Schichten. Die Belichtungszeiten können drastisch reduziert werden unter sonst vergleichbaren Verfahrensbedingungen, d.h. ohne daß andere Nachteile in Kauf genommen werden müssen.

Das erfindungsgemäße Verfahren kann auch so durchgeführt werden, daß man das lichtempfindliche Material unter einer Negativ-Vorlage belichtet, danach erwärmt, ganzflächig belichtet und dann in den Nichtbildbereichen mittels Laser- oder Elektronenstrahlen oder eines Thermodruckers bebildert. Eine weitere Verfahrensvariation besteht darin, daß man das lichtempfindliche Material unter einer Negativ-Vorlage belichtet, danach erwärmt, an den Nichtbildstellen unter einer Positiv-Vorlage belichtet und danach in den verbliebenen Nichtbildbereichen mit Laser- oder Elektronenstrahlen oder mit einem Thermodrucker bebildert. Man erwärmt das unter einer Neagtiv-Vorlage belichtete Material vorzugsweise auf eine Temperatur von 90 bis 140 ° C und führt die Erwärmung innerhalb von 30 Sekunden bis 5 Minuten durch.

Infolge der hier genannten verschiedenen Kombinationsmöglichkeiten zur Bebilderung einer Druckplatte mit unterschiedlichen Raster- und/oder Strichelementen wird die Herstellung einer Druckform wesentlich erleichtert. Das erfindungsgemäße Verfahren hat ferner den Vorteil gegenüber der konventionellen Arbeitsweise der Druckformenherstellung, bei der bekanntlich Raster und Text auf einen gemeinsamen Film montiert bzw. kopiert werden müssen, daß Raster bzw. Bilder und Text unabhängig voneinander auf getrennten Filmen montiert oder aus digitalen Datenträgern entnommen und unabhängig voneinander auf die gleiche Druckplatte kopiert werden können. Das bedeutet bemerkenswerte Einsparungen an Zeit und Filmmaterial.

Als Verbindungen, die bei Belichtung eine starke Säure bilden, sind eine große Anzahl von bekannten Verbindungen und Mischungen, wie Phosphonium-, Sulfonium- und Jodoniumsalze, Halogenverbindungen und Organometall-Organohalogen-Kombinationen geeignet.

Die genannten Phosphonium-, Sulfonium- und Jodoniumverbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige lichtempfindliche und Halogenwasserstoffsäure bildende Verbindungen alle auch als photochemische Radikalstarter bekannten organischen Halogenverbindungen, beispielsweise solche mit mehr als einem Halogenatom an einem Kohlenstoffatom oder an einem aromatischen Ring, brauchbar. Beispiele sind in den US-PS 3 515 552, 3 536 489 und 3 779 778, den DE-PS 26 10 842, DE-OS 22 43 621, 27 18 259 und 33 37 024 beschrieben. Von diesen Verbindungen werden die s-Triazinderivate mit 2 Halogenmethylgruppen, insbesondere Trichlormethylgruppen, und einem aromatischen bzw. ungesättigten Substituenten im Triazinkern, bevorzugt. Ebenso gut geeignet sind die in den DE-OS 28 51 471 und 29 49 396 beschriebenen 2-Trichlormethyl1,3,4-oxadiazole. Die Wirkung dieser halogenhaltigen Verbindungen kann auch durch bekannte Sensibilisatoren spektral beeinflußt und gesteigert werden.

Beispiele für geeignete Starter sind:
4-Methyl-6-trichlormethyl-2-pyron, 4-(3,4,5-Trimethoxy-styryl)6-trichlormethyl-2-pyron, 4-(4-Methoxy-styryl)-6-(3,3,3-trichlor-propenyl)-2-pyron, 2-Trichlormethylbenzimidazol, 2-Tribrommethyl-chinolin, 2,4-Dimethyl-1-tribromacetylbenzol, 3-Nitro-1-tribromacetyl-benzol, 4-Dibrommethyl-s-triazin, 1,4-Bis-dibromacetyl-benzol, Tris-dibrommethyl-s-triazin, 2-(6-Methoxy-naphth-2-yl)-, 2-(Naphth-1-yl)-, 2-(Naphth-2-yl)-, 2-(4-Ethoxy-ethyl-naphth-1-yl)-2-(Benzopyran-3-yl)-, 2-(4-Methoxy-anthrac-1-yl)-, 2-(4-Styryl-phenyl)-, 2-(Phenanthr-9-yl)-4,6-bis-trichlormethyl-s-triazin .

Die Mengen des Starters kann je nach seiner chemischen Natur und der Zusammensetzung der Schicht ebenfalls verschieden sein. Günstige Ergebnisse werden erhalten mit etwa 0,5 bis 20 Gewichtsprozent, bezogen auf den Gesamtfeststoff, bevorzugt sind 1,0 bis 12 %. Besonders für lichtempfindliche Schichten von Dicken über 0,01 mm empfiehlt es sich, relativ wenig Säurespender zu verwenden.

Als durch Säure spaltbare Verbindungen sind in erster Linie zu nennen:

A) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,

B) Oligomer- oder Polymerverbindungen mit wiederkehrenden Acetal- und/oder Ketalgruppierungen in der Hauptkette und

C) Verbindungen mit mindestenes einer Enolether- oder N-Acyliminocarbonatgruppierung.

Durch Säure spaltbare Verbindungen als Komponenten lichtempfindlicher Gemische sind in der US-PS 4 101 323 und in der EP-OS 0 022 571 ausführlich beschrieben.

Als Verbindung mit mindestens einer durch Säure spaltbaren Bindung wird vorzugsweise Polyacetal, inbesondere ein solches, das aus Triethylenglykol und 2-Ethylbutyraldehyd hergestellt wurde, verwendet.

Weitere durch Säure spaltbare Verbindungen sind solche, die mindestenes eine Silylethergruppe der Formel

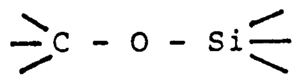

enthalten.

Derartige Verbindungen sind beispielsweise beschrieben in DE-OS 35 44 165 oder in EP-OS 0 130 599.

Der Anteil der spaltbaren Verbindung kann variiert werden zwischen 4 und 50 Gewichtsprozent, bevorzugt werden 5 bis 30 Gewichtsprozent, bezogen auf die nichtflüchtigen Bestandteile der lichtempfindlichen Schicht.

Die lichtempfindliche Schicht enthält ferner ein polymeres, wasserunlösliches Bindemittel, das in organischen Lösungsmitteln löslich ist. Da sich als Entwicklerflüssigkeiten für die belichteten Schichten mit Vorteil wäßrigalkalische Lösungen einsetzen lassen und diese im allgemeinen gegenüber Entwicklern auf Basis organischer Lösungsmittel vorgezogen werden, werden solche Bindemittel verwendet, die in wäßrigen Alkalien löslich oder mindestens quellbar sind.

Die Art und Menge der Bindemittel kann je nach Anwendungszweck verschieden sein; bevorzugt sind Anteile am Gesamtfeststoff zwischen 30 und 90, insbesondere zwischen 50 - 80 Gewichtsprozent.

Die bei vielen Positiv-Kopiermaterialien bewährten Phenolharze, vor allem Novolake, haben sich auch bei den erfindungsgemäßen Materialien als besonders brauchbar und vorteilhaft erwiesen. Sie fördern die starke Differenzierung zwischen den belichteten und unbelichteten Schichtpartien beim Entwicklen, besonders die höher kondensierten Harze mit substitierten Phenolen, z.B. Kresolen, als Formaldehyd-Kondensationspartner. Die Novolake können auch in bekannter Weise durch Umsetzung eines Teils ihrer Hydroxygruppen, z.B. mit Chloressigsäure, Isocyanaten, Epoxiden oder Carbonsäureanhydriden, modifiziert sein. Mischpolymerisate aus Maleinsäureanhydrid und Styrol, Vinylacetat und Crotonsäure, Methylmethacrylat und Methacrylsäure oder Polymerisate bzw. Copolymerisate aus Acryl- oder Methacrylsäurephenolestern, werden bevorzugt.

Zusätzlich können noch zahlreiche andere Harze mitverwendet werden, die entweder wasserlöslich oder alkali-unlöslich sein können, bevorzugt Vinylpolymerisate wie Polyvinylacetate, Polyacrylate, Polyvinylether und Polyvinylpyrrolidone, die selbst durch Comonomere modifiziert sein können. Der günstigste Anteil an diesen Harzen richtet sich nach den anwendungstechnischen Erfordernissen und dem Einfluß auf die Entwicklungsbedingungen und beträgt im allgemeinen nicht mehr als 20 % vom alkalilöslichen Harz. In geringen Mengen kann die lichtempfindliche Schicht für spezielle Erfordernise wie Flexibilität, Haftung, Glanz etc. außerdem noch Substanzen wie Polyglykole, Celluloseether, z.B. Ethylcellulose, Netzmittel, Farbstoffe und feinteilige Pigmente enthalten.

Schließlich können der lichtempfindlichen Schicht noch lösliche oder auch feinteilige dispergierbare Farbstoffe sowie je nach Anwendungszeck auch UV-Absorber zugesetzt werden. Als Farbstoffe haben sich die Triphenylmethanfarbstoffe, insbesondere in der Form ihrer Carbinolbasen, besonders bewährt. Die günstigsten Mengenverhältnisse der Komponenten lassen sich im Einzelfall durch Vorversuche leicht ermitteln.

Die Schichtdicke der lichtempfindlichen Schicht richtet sich im wesentlichen nach dem vorgesehenen Anwendungszweck des Materials. Sie kann im allgemeinen zwischen etwa 500 nm und 0,08 mm, vorzugsweise 0,001 bis 0,05 mm liegen. Für Druckplatten und aus Lösungen aufzubringende Photoresistschichten

werden Schichtdicken im Bereich von 0,001 bis 0,01 mm bevorzugt.

Als Schichtträger für die lichtempfindlichen Gemische eignen sich alle üblicherweise in der Technik in Kopierprozessen eingesetzten Materialien. Als Beispiele seien Papier, Kunststoffolien, Isolierplatten mit Kupferauflage, mechanisch oder elektrochemisch aufgerauhtes und ggf. anodisiertes Aluminium, Siebdruckschablonenträger, Holz, Keramik, Glas und Silicium, dessen Oberfläche chemisch z.B. in Siliciumnitrid oder Siliciumdioxid umgewandelt sein kann, genannt.

Bevorzugte Träger für dicke Schichten über 0,01 mm sind Kunststoffolien, die dann als temporäre Träger für Transferschichten dienen. Dafür und für Farbfolien werden Polyesterfolien, z.B. aus Polyethylenterephthalat, bevorzugt. Polyolefinfolien wie Polypropylen sind ebenfalls geeignet. Als Schichtträger für Schichtdicken unter ca. 0,01 mm werden meist Metalle verwendet. Für Offsetdruckplatten können eingesetzt werden: mechanisch oder chemisch aufgerauhtes und gegebenenfalls anodisiertes Aluminium, das zudem noch chemisch, z.B. mit Polyvinylphosphonsäure, Silikaten, Phosphaten, Hexafluorzirkonaten oder mit hydrolysiertem Tetraethylorthosiliakt, vorbehandelt sein kann, außerdem Mehrmetallplatten mit Cu/Cr oder Messing/Cr als oberster Schicht.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone wie Methylethylketon, chlorierte Kohlenwasserstoffe wie Trichlorethylen und 1,1,1,-Trichlorethan, Alkohole wie n-Propanol, Ether wie Tetrahydrofuran, Alkoholether wie Ethylen- bzw. Propylenglykolmonoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit dem Schichtkomponenten nicht irreversibel reagieren. Partialether von Glykolen, insbesondere Ethylenglykolmonomethylether und Propylenglykolmonomethylether, werden besonders bevorzugt.

Die Beschichtung des Trägermaterials erfolgt in bekannter Weise durch Aufschleudern, Sprühen, Tauchen, Walzen mittels Breitschlitzdüsen, Rakeln oder durch Gießer-Antrag.

Zum Entwickeln werden wäßrig-alkalische Lösungen abgestufter Alkalität verwendet, vorzugsweise mit einem pH im Bereich von 10 - 14, die auch kleinere Mengen organischer Lösungs- oder Netzmittel enthalten können. Als Entwickler sind vorzugsweise wäßrige Lösungen von alkalischen Substanzen, z.B. von Alkaliphosphaten, -silikaten, -carbonaten oder -hydroxiden geeignet, die ferner Netzmittel oder kleinere Mengen organischer Lösungsmittel enthalten können. In bestimmten Fällen sind auch organische Lösungsmittel oder Gemische derselben mit Wasser als Entwickler geeignet.

Das erfindungsgemäße Verfahren kann zum Beispiel zur Herstellung einer Druckform für den Hoch-, Tief- und Flachdruck sowie von Photoresistschablonen für die substraktive und additive Leiternplattenherstelllung, für die galvanische Herstellung von Nickelrotationszylindern oder für die Maskenherstellung in der Mikroelektronik nach der Lift-off-Technik eingesetzt werden.

Die folgenden Beispiele beschreiben Ausführunfgsformen des erfindungsgemäßen Verfahrens. Prozentzahlen und Mengenverhältnisse sind, wenn nichts anderes angegeben ist, in Gewichtseinheiten zu verstehen.

Beispiel 1:

Mit einer Lösung von

| | |
|---|---|
| 1,600 Gt | eines Polyacetals, hergestellt aus Triethylenglykol und 2-Ethylbutyraldehyd, |
| 0,300 Gt | 2,4-Bis-(trichlormethyl)-6-p-stilbenyl-s-triazin, |
| 6,000 Gt | eines Kresol-Formaldehyd-Novolaks mit einem Erweichungspunkt von 127 - 145 °C, |
| 0,050 Gt | Kristallviolett-Base in |
| 40,00 Gt | Ethylenglykolmonomethylether und |
| 40,00 Gt | Tetrahydrofuran |

wird eine elektrochemisch aufgerauhte und anodisierte Aluminiumplatte beschichtet. Das so hergestellte licht empfindliche Material hat ein Schichtgewicht von 2,75 g/m$^2$.

Zwecks Herstellung einer Druckform wird die Kopierschicht zunächst ohne Vorlage mit einer der üblichen Kopierlampen vollflächig ausbelichtet. Anschließend wird mit einem Krypton-Laser im sichtbaren Bereich, hauptsächlich mit den Wellenlängen 647 und 676 nm, mit 4 Watt Strahlenleistung und einer Aufzeichnungsgeschwindigkeit von 1 cm/sec bildmäßig bestrahlt. Ohne weitere Zwischenbehandlung wird

die Druckplatte dann mit einer 5 %igen wäßrig-alkalischen Natriumsilikatlösung entwickelt, wobei die nicht vom Laserstrahl getroffenen Schichtbereiche entfernt werden. Die vom Laserstrahl getroffenen Stellen sind oleophil gehärtet, nehmen in einer Offsetdruckmaschine fette Farbe an und erlauben eine gute Druckauflage.

Eine andere Anwendungsmöglichkeit der Erfindung sind die verschiedenen Kombinationsmöglichkeiten beim Zusammenkopieren von Strich- und/oder Rasterfilmen, ähnlich wie dies von dem Photocomposing-Verfahren bekannt ist. So wird beispielsweise die oben hergestellte Druckplatte zunächst unter einer Positiv-Vorlage mit Hilfe einer Metall-Halogenid-Lampe von 500 Watt bei einem Lampenabstand von 103 cm mit 15 Takten bildmäßig belichtet und anschließend an den noch nicht bebilderten Schichtbereichen mit Hilfe eines Laserstrahls, beispielsweise mit einem Krypton-Laser, wie oben angegeben, bildmäßig bestrahlt. Die so bildmäßig belichtete und bestrahlte Druckplatte wird ohne weitere Zwischenschritte mit einer 5 %igen wäßrig-alkalischen Natriumsilikatlösung entwickelt, wobei die fertige Druckform erhalten wird.

Zur Bildumkehr wird die oben hergestellte normalerweise positiv arbeitende Druckplatte 15 Takte lang unter einer Negativ-Vorlage belichtet, anschließend 2 Minuten bei 125 °C getempert, mit 15 Takten ganzflächig nachbelichtet und mit einer 5 %igen Natriumsilikatlösung entwickelt, wobei die fertige Druckform erhalten wird.

Nach einer weiteren Bebilderungsmöglichkeit wird die unter einer Negativ-Vorlage belichtete Druckplatte zunächst 2 Minuten bei 125 °C getempert und ganzflächig nachbelichtet. Anschließend wird an den Nichtbildbereichen, die während der ersten Belichtung abgedeckt waren, mit Hilfe eines Krypton-Lasers, hauptsächlich mit den Wellenbereichen 647 und 676 nm, mit 4 Watt Strahlenleistung und einer Aufzeichnungsgeschwindigkeit von 1 cm/sec bildmäßig bestrahlt. Nach der Entwicklung mit einer 5 %igen wäßrigen Lösung von Natriumsilikat wird die fertige Druckform erhalten.

Um die ausgezeichnete Lichtempfindlichkeit der erfindungsgemäßen Kopierschichten zu zeigen, wird das oben verwendete Polyacetal durch die gleiche Menge einer o-Chinondiazidverbindung ersetzt, beispielsweise durch das Umsetzungsprodukt aus 1 mol 2,3,4-Trihydroxybenzophenon und 3 mol 1,2-Naphthochinon-2-diazid-5-sulfonsäurechlorid, und unter sonst gleichen Bedingungen eine entsprechende Druckplatte hergestellt. Bei der Belichtung unter einer Positiv-Testvorlage mit einmontiertem Halbtonstufenkeil muß bei der chinondiazidhaltigen Druckplatte mit 150 Takten belichtet werden, um das gleiche kopiertechnische Ergebnis zu erzielen, beispielsweise die gleiche Länge des Halbtonstufenkeils, wie es mit der erfindungsgemäß hergestellten Druckplatte erhalten wird, die unter gleichen Versuchsbedingungen nur mit 15 Takten belichtet wurde.

Dieses Vergleichsbeispiel macht deutlich, daß die vorsensibilisierten Druckplatten gemäß der Erfindung eine höhere Lichtempfindlichkeit haben und damit eine wesentlich geringere Belichtungszeit erfordern als die entsprechenden mit o-Chinondiaziden hergestellten Kopierschichten, wie sie beispielsweise auch in US-PS 4 544 627, eingesetzt werden. Infolge der relativ hohen Lichtempfindlichkeit der gemäß der Erfindung verwendeten Kopierschichten können die Zeiten für die verschiedenen Bebilderungsmöglichkeiten entsprechend der Erfindung wesentlich abgekürzt werden.

Beispiel 2:

Mit einer Lösung von

| | |
|---|---|
| 1,400 Gt | eines Polyorthoesters, hergestellt aus 7,7-Bis-hydroxymethyl-5-oxa-nonanol-(1) und Ortho-ameisensäuretrimethylester, |
| 0,25 Gt | 2,4-Bis-(trichlormethyl)-6-p-stilbenyl-s-triazin, |
| 5,00 Gt | eines Kresol-Formaldehyd-Novolaks mit einem Erweichungspunkt von 127 - 145 °C, |
| 0,040 Gt | Kristallviolett-Base in |
| 40,00 Gt | Propylenglykolmethylether und |
| 40,00 Gt | Tetrahydrofuran |

wird eine elektrochemisch aufgerauhte und anodisierte Aluminiumplatte beschichtet.

Das so hergestellte vorsensibilisierte Material mit einem Schichtgewicht von ca. 2,30 g/$m^2$ wurde zunächst als Negativ-Druckplatte verarbeitet. Zu diesem Zweck wurde die Probe unter einer negativen Vorlage bildmäßig mit 20 Takten belichtet, anschließend 2 Minuten auf 130 °C in einem Temperofen erwärmt und dann ohne Vorlage mit derselben Zeit wie bei der bildmäßigen Negativ-Belichtung nachbelichtet. Anschließend wird an den Nichtbildbereichen des Negativbildes mittels eines Krypton-Lasers, hauptsächlich mit den Wellenlängen 647 und 676 nm, mit 6 Watt Strahlenleistung und einer Aufzeichnungsgeschwindigkeit von 1 cm/sec bildmäßig bestrahlt. Nach der Entwicklung mit einer 3 %igen wäßrig-alkalischen Natriumsilikatlösung wird die fertige Druckform erhalten.

Beispiel 3:

Mit einer Lösung von

| | |
|---|---|
| 1,600 Gt | eines Polyacetals, hergestellt aus Triethylenglykol und 2-Ethylbutyraldehyd, |
| 0,300 Gt | 2,4-Bis-(trichlormethyl)-6-(4-ethoxy-naphth-1-yl)s-triazin, |
| 6,000 Gt | eines Kresol-Formaldehyd-Novolaks mit einem Erweichungspunkt von 127 - 145 °C, |
| 0,050 Gt | Kristallviolett-Base in |
| 40,00 Gt | Ethylenglykolmonomethylether und |
| 40,00 Gt | Tetrahydrofuran |

wird eine elektrochemisch aufgerauhte und anodisierte Aluminiumplatte beschichtet. Das so hergestellte lichtempfindliche Material hat ein Schichtgewicht von 2,80 $g/m^2$.

Zur Herstellung einer Druckform wird das so hergestellte lichtempfindliche Material mit UV-Licht vollflächig ausbelichtet und anschließend mit einem Argon-Laser im sichtbaren Bereich, hauptsächlich mit den Wellenlängen 488 und 514 nm, mit 5 Watt Strahlenleistung und einer Aufzeichnungsgeschwindigkeit von 1 cm/sec bildmäßig bestrahlt. Nach der Entwicklung mit einer 5 %igen wäßrigalkalischen Natriumsilikatlösung wir die fertige Druckform erhalten.

Nach einer weiteren Anwendungsform wird die oben hergestellte Druckplatte zunächst unter einer Positiv-Vorlage bildmäßig mit UV-Licht belichtet und anschließend in dem noch nicht bebilderten Schichtbereich mit Hilfe des oben angegegebenen Lasers bildmäßig bestrahlt. Die so bildmäßig belichtete und bestrahlte Druckplatte wird ohne weitere Zwischenschritte mit einer 5 %igen wäßrig-alkalischen Natriumsilikatlösung entwickelt, wobei die fertige Druckform erhalten wird.

Beispiel 4:

Mit einer Lösung von

| | |
|---|---|
| 1,800 Gt | eines Polyorthoesters, hergestellt aus 7,7-Bis-hydroxymethyl-5-oxa-nonanol-(1) und Ortho-ameisensäuretrimethylester, |
| 0,300 Gt | 2,4-Bis-(trichlormethyl)-6-p-(4-ethoxy-naphth-1-yl)-s-triazin, |
| 6,00 Gt | eines Kresol-Formaldehyd-Novolaks mit einem Schmelzbereich von 127 - 145 °C, |
| 0,050 Gt | Kristallviolett-Base in |
| 40,00 Gt | Ethylenglykolmonomethylether und |
| 40,00 Gt | Tetrahydrofuran |

wurde eine elektrochemisch aufgerauhte und anodisierte Aluminiumplatte beschichtet.

Das so hergestellte lichtempfindliche Material mit einem Schichtgewicht von ca. 2,60 $g/m^2$ wurde unter einer transparenten Positiv-Vorlage, wie in Beispiel 1 angegeben, bildmäßig belichtet und anschließend wurden die belichteten Schichtbereiche mit einem Elektronenstrahl der Stromstärke 1 $\mu A$ und der Beschleunigungsspannung von 20 KV bebildert. Nach der Entwicklung mit einer 4 %igen wäßrigalkalischen Natriumsilikatlösung wurde die fertige Druckform erhalten.

Beispiel 5:

Mit einer Lösung von

| | |
|---|---|
| 1,600 Gt | eines Polyacetals, hergestellt aus Triethylenglykol und 2-Ethylbutyraldehyd, |
| 0,300 Gt | 2,4-Bis-(trichlormethyl)-6-p-stilbenyl-s-triazin, |
| 6,000 Gt | eines Kresol-Formaldehyd-Novolaks mit einem Erweichungspunkt von 127 - 145 °C, |
| 0,050 Gt | Kristallviolett-Base in |
| 40,00 Gt | Ethylenglykolmonomethylether und |
| 40,00 Gt | Tetrahydrofuran |

wurden eine geeignete Polyesterfolie und eine entsprechend vorbehandelte Papierfolie, beispielsweise eine nach den Angaben der amerikanischen Patentschrift 2 681 617 hergestellte Papierfolie, beschichtet. Das so hergestellte lichtempfindliche Material wurde zunächst ohne Vorlage mit einer der üblichen Kopierlampen vollflächig ausbelichtet und anschließend mit einem Thermodrucker behandelt. Durch die Temperatur des Thermokopfes (150 - 200 °C) wird die Kopierschicht an den von dem Thermokopf berührten Schichtbereichen irreversibel verändert und wird oleophil und im Entwickler unlöslich. Nach dem Entwickeln mit einer 5 %igen wäßrigen Lösung von Natriummetasilikat wurden fertige Druckformen erhalten.

Beispiel 6:

Mit einer Lösung von

| | |
|---|---|
| 1,600 Gt | eines Polysilylethers, hergestellt aus Dichlordimethylsilan und 1,4-Bis-(2-hydroxyethoxy)-benzol, |
| 0,300 Gt | 2,4-Bis-(trichlormethyl)-6-p-stilbenyl-s-triazin, |
| 5,600 Gt | eines Kresol-Formaldehyd-Novolaks |
| 0,050 Gt | Kristallviolett-Base in |
| 40,00 Gt | Ethylenglykolmonomethylether und |
| 50,00 Gt | Tetrahydrofuran |

wird eine elektrochemisch aufgerauhte und anodisierte Aluminiumplatte beschichtet. Das so hergestellte lichtempfindliche Material hat ein Schichtgewicht von 2,45 $g/m^2$.

Zwecks Herstellung einer Druckform wird die Kopierschicht zunächst ohne Vorlage mit einer der üblichen Kopierlampen vollflächig ausbelichtet. Anschließend wird mit einem Krypton-Laser im sichtbaren Bereich, hauptsächlich mit den Wellenlängen 647 und 676 nm, mit 4 Watt Strahlenleistung und einer Aufzeichnungsgeschwindigkeit von 1 cm/sec bildmäßig bestrahlt. Ohne weitere Zwischenbehandlung wird die Druckplatte dann mit einer 5 %igen wäßrig-alkalischen Natriumsilikatlösung entwickelt, wobei die nicht vom Laserstrahl getroffenen Schichtbereiche entfernt werden. Die vom Laserstrahl getroffenen Stellen sind oleophil und gehärtet, nehmen in einer Offsetdruckmaschine fette Farbe an und erlauben eine gute Druckauflage.

Beispiel 7:

Mit einer Lösung von

| | |
|---|---|
| 1,600 Gt | eines Polysilylethers, hergestellt aus Dichlordimethylsilan und Bis-(2-hydroxyethyl)-2,4-toluylendicarbamat, |
| 0,300 Gt | 2,4-Bis-(trichlormethyl)-6-p-methoxystyryl-s-triazin, |
| 6,00 Gt | eines Kresol-Formaldehyd-Novolaks |
| 0,055 Gt | Kristallviolett-Base |
| 40,00 Gt | Propylenglykolmethylether und |
| 50,00 Gt | Tetrahydrofuran |

wird eine elektrochemisch aufgerauhte und anodisierte Aluminiumplatte beschichtet.

Die Druckplatte wird unter einer Positiv-Vorlage mit Hilfe einer Metall-Halogenid-Lampe von 500 Watt bei einem Lampenabstand von 103 cm mit 10 Takten bildmäßig belichtet und anschließend in den noch nicht bebilderten Schichtbereichen mit Hilfe eines Laserstrahls, beispielsweise mit einem Krypton-Laser wie oben angegeben, bildmäßig bestrahlt. Die so bildmäßig belichtete und bestrahlte Druckplatte wird ohne

weitere Zwischenschritte mit einer 5 %igen wäßrig-alkalischen Natriumsilikatlösung entwickelt, wonach man die fertige Druckform erhält.

## Patentansprüche

1. Verfahren zur Bebilderung lichtempfindlichen Materials aus einem Schichtträger und einer normalerweise positiv arbeitenden lichtempfindlichen Schicht, bei dem man die lichtempfindliche Schicht durch Belichtung mittels UV-Licht aktiviert, die Bebilderung mittels thermischer Energie vornimmt und die Entwicklung mit einem wäßrig-alkalischen Entwickler durchführt, dadurch gekennzeichnet, daß man in der lichtempfindlichen Schicht ein Gemisch aus einer Verbindung mit mindestens einer durch Säure spaltbaren -C-O-C-oder -C-O-Si- Bindung und einer bei Belichtung eine starke Säure bildenden Verbindung verwendet und die Bebilderung durch thermische Härtung in dem aktivierten Bereich mittels Laser- oder Elektronenstrahlen oder mit Hilfe eines Thermodruckers durchführt.

2. Verfahren nach Anspruch 1, dadurch gekennzeichnet, daß man zur Bebilderung einen Hochleistungs-Ionenlaser mit einer Emission über 500 nm verwendet.

3. Verfahren nach Anspruch 1, dadurch gekennzeichnet, daß man zur Bebilderung Elektronenstrahlen mit einer Stromstärke von mindestens 1 µA und einer Beschleunigungsspannung von 10 kV verwendet.

4. Verfahren nach Anspruch 1, dadurch gekennzeichnet, daß man die Bebilderung durch eine punktweise Erwärmung mit einem Thermodrucker durchführt.

5. Verfahren nach Ansprüchen 1 bis 4, dadurch gekennzeichnet, daß man das lichtempfindliche Material unter einer Positiv-Vorlage belichtet und in den Nichtbildbereichen des Positivbildes mittels Laser-, Elektronenstrahlen oder eines Thermodruckers bebildert.

6. Verfahren nach Anspruch 1, dadurch gekennzeichnet, daß man das lichtempfindliche Material unter einer Negativ-Vorlage belichtet, danach erwärmt, ganzflächig belichtet und dann in den Nichtbildbereichen mittels Laser- oder Elektronenstrahlen oder eines Thermodruckers bebildert.

7. Verfahren nach Anspruch 1, dadurch gekennzeichnet, daß man das lichtempfindliche Material unter einer Negativ-Vorlage belichtet, danach erwärmt, an den Nichtbildstellen unter einer Positiv-Vorlage belichtet und danach in den verbliebenen Nichtbildbereichen mit Laser-oder Elektronenstrahlen oder mit einem Thermodrucker bebildert.

8. Verfahren nach Ansprüchen 6 oder 7, dadurch gekennzeichnet, daß man das unter einer Negativ-Vorlage belichtete Material auf eine Temperatur von 90 - 140 °C erwärmt.

9. Verfahren nach Ansprüchen 6 oder 7, dadurch gekennzeichnet, daß man das unter einer Negativ-Vorlage belichtete Material 30 Sekunden bis 5 Minuten erwärmt.

10. Verfahren nach Anspruch 1, dadurch gekennzeichnet, daß man als Verbindung mit mindestens einer durch Säure spaltbaren Bindung Polyacetal verwendet.

11. Verfahren nach Anspruch 10, dadurch gekennzeichnet, daß man als Verbindung mit mindestens einer durch Säure spaltbaren Bindung ein Polyacetal verwendet, das aus Triethylenglykol und 2-Ethylbutyraldehyd hergestellt wurde.

## Claims

1. A process for producing images on a photosensitive material comprising a support and a normally positive-working photosensitive layer, the process comprising activating the photosensitive layer by exposure to ultraviolet light, imaging by means of thermal energy, and developing with an aqueous-alkaline developer, wherein a mixture composed of a compound containing at least one -C-O-C- or -C-O-Si- bond which can be split by acid and a compound forming a strong acid upon exposure is employed in the photosensitive layer and imaging by thermal hardening in the activated region is carried out by means of laser or electron beams or with the aid of a thermal printer.

2. A process as claimed in claim 1, wherein a high-power ion laser emitting at wavelengths above 500 nm is used for imaging.

3. A process as claimed in claim 1, wherein electron beams having a current strength of at least 1 $\mu$A and an accelerating voltage of 10 kV are used for imaging.

4. A process as claimed in claim 1, wherein imaging is carried out by point-for-point heating using a thermal printer.

5. A process as claimed in claims 1 to 4, wherein the photosensitive material is exposed under a positive original and an image is then produced in the non-image areas of the positive image by means of laser beams, electron beams or a thermal printer.

6. A process as claimed in claim 1, wherein the photosensitive material is exposed under a negative original, thereafter heated and subjected to an overall exposure and an image is then produced in the non-image areas by means of laser beams, electron beams or a thermal printer.

7. A process as claimed in claim 1, wherein the photosensitive material is exposed under a negative original, thereafter heated and exposed under a positive original in the non-image areas and an image is then produced in the remaining non-image areas by means of laser beams, electron beams or a thermal printer.

8. A process as claimed in claim 6 or claim 7, wherein the material which has been exposed under a negative original is heated at a temperature of from 90 to 140 °C.

9. A process as claimed in claim 6 or claim 7, wherein the material which has been exposed under a negative original is heated for a duration of from 30 seconds to 5 minutes.

10. A process as claimed in claim 1, wherein a polyacetal is used as the compound containing at least one bond which can be split by acid.

11. A process as claimed in claim 10, wherein a polyacetal prepared from triethylene glycol and 2-ethylbutyraldehyde is used as the compound containing at least one bond which can be split by acid.

**Revendications**

1. Procédé de production d'images sur un matériau photosensible composé d'un support et d'une couche photosensible fonctionnant normalement en positif, le procédé comprenant l'activation de la couche photosensible par exposition à la lumière ultraviolette, la production d'images par énergie thermique et développement avec un développeur alcalin en solution aqueuse, caractérisé en ce qu'on utilise, dans la couche photosensible, un mélange comprenant un composé contenant au moins une liaison -C-O-C- ou -C-O-Si- qui peut être brisée par acide et un composé formant un acide fort après exposition et en ce que la production d'images par durcissement thermique dans la zone activée est réalisée au moyen de faisceaux laser ou d'électrons ou avec l'aide d'une imprimante thermique.

2. Procédé suivant la revendication 1, caractérisé en ce qu'on utilise un laser ionique de puissance élevée émettant avec des longueurs d'ondes supérieures à 500 nm pour la production d'images.

3. Procédé suivant la revendication 1, caractérisé en ce qu'on utilise des faisceaux d'électrons ayant un courant d'au moins 1 $\mu$A et une tension d'accélération de 10 kV pour la production d'images.

4. Procédé suivant la revendication 1, caractérisé en ce que la production d'images est effectuée par un chauffage point par point utilisant une imprimante thermique.

5. Procédé suivant les revendications 1 à 4, caractérisé en ce que le matériau photosensible est exposé sous un original positif et une image est alors produite dans les zones sans image de l'image positif au moyen de faisceaux de laser, de faisceaux d'électrons ou d'une imprimante thermique.

**6.** Procédé suivant la revendication 1, caractérisé en ce que le matériau photosensible est exposé sous un original négatif, par la suite chauffé et soumis à une exposition totale et une image est alors produite dans les zones sans image au moyen de faisceaux laser, de faisceaux d'électrons ou d'une imprimante thermique.

**7.** Procédé suivant la revendication 1, caractérisé en ce que le matériau photosensible est exposé sous un original négatif, par la suite chauffé et exposé sous un original positif dans les zones sans image et une image est alors produite dans les zones sans image restantes au moyen de faisceaux laser, de faisceaux d'électrons ou d'une imprimante thermique.

**8.** Procédé suivant la revendication 6 ou 7, caractérisé en ce que le matériau qui a été exposé sous un original négatif est chauffé à une température comprise entre 90 et 140 ° C.

**9.** Procédé suivant la revendication 6 ou 7, caractérisé en ce que le matériau qui a été exposé sous un original négatif est chauffé pendant une durée comprise entre 30 secondes et 5 minutes.

**10.** Procédé suivant la revendication 1, caractérisé en ce qu'on utilise un polyacétale comme composé contenant au moins une liaison qui peut être brisée par un acide.

**11.** Procédé suivant la revendication 10, caractérisé en ce que l'on utilise un polyacétale fabriqué à partir de glycol triéthylène et de 2-éthylbutyraldéhyde comme composé contenant au moins une liaison qui peut être brisée par un acide.